Europäisches Patentamt

European Patent Office

Office européen des brevets

(11) Publication number: **0 118 629**
**B1**

(12) EUROPEAN PATENT SPECIFICATION

(45) Date of publication of patent specification: **17.01.90**

(51) Int. Cl.⁵: **H 05 K 13/04**

(21) Application number: **83300683.6**

(22) Date of filing: **10.02.83**

(54) Electronic component insertion apparatus.

(43) Date of publication of application:
**19.09.84 Bulletin 84/38**

(45) Publication of the grant of the patent:
**17.01.90 Bulletin 90/03**

(84) Designated Contracting States:
**DE FR GB**

(56) References cited:
**NL-C- 106 422**
**US-A-3 539 086**
**US-A-4 205 433**

(73) Proprietor: **Matsushita Electric Industrial Co.,
Ltd.**
**1006, Oaza Kadoma**
**Kadoma-shi Osaka-fu, 571 (JP)**

(72) Inventor: **Fujiwara, Koji**
**92-13 Yadayama-cho**
**Yamato Kouriyama city Nara (JP)**
Inventor: **Maeda, Yoshinobu**
**15-17 Myoukenzaka 3-chome**
**Katano city Osaka (JP)**

(74) Representative: **Crawford, Andrew Birkby et al
A.A. THORNTON & CO. Northumberland House
303-306 High Holborn
London WC1V 7LE (GB)**

Courier Press, Leamington Spa, England.

## Description

The present invention relates to an apparatus for automatically inserting various types of electronic components having axially extending lead wires into predetermined apertures in a print circuit board, according to the first part of claim 1, and as known e.g. from the document US—A—4 205 433.

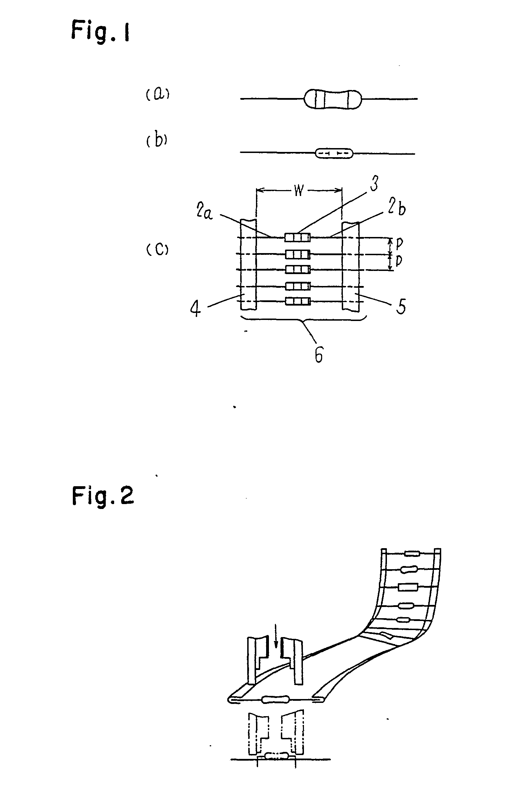

Conventionally, apparatuses for continuously and automatically inserting different types of electric components having axially extending lead wires, such as resistors (Fig. 1a) and diodes (Fig. 1b), are classified into two types according to the way said electronic components are fed into the apparatus. According to the first type, an electric component assembly comprising different types of electric components arranged, e.g., on a band in a predetermined insertion sequence is prepared in advance and is inserted into an insertion head for successive insertion (Fig. 2). According to the second type, a required number of different types of assemblies each comprising electric components of the same type arranged in band form are prepared and these assemblies are successively selected in the order of insertion and the electric components are separated from each assembly and conveyed to an insertion head by a belt, pipe or other means. However, each type of apparatus has its own drawbacks as described below.

In the first type, different types of components must be sequentially arranged in tape form in the order of insertion and even if a failure in insertion takes place for one reason or another, reinsertion is impossible.

In the second type, the use of a conveyor or pipe for transfer tends to cause rotation or tilting of components, making it impossible to feed them into the insertion head in a stabilized manner. Further, transfer takes so much time as to make it impossible to accelerate the insertion cycle. A further drawback is that the conveyor or pipe can damage the components or deform the lead wires.

On the other hand, new types of insertion apparatuses eliminating the drawbacks of said apparatus capable of continuously inserting different components have already been proposed and put into practical use. For example, USP No. 4,205,433 discloses such an apparatus comprising means for arranging and holding a plurality of taped assemblies of the same type of electronic components and for moving one of said electronic component assemblies to a predetermined component feed position in response to an instruction, and an insertion head adapted to travel between said component feed position and a second position adjacent to a print circuit board so as to feed a single electronic component cut off from the electronic component assembly and shaped at said component feed position to said second position, where it inserts the electronic component into said print circuit board. This type is called the random access type, whereas the first type is called the sequential type. The insertion apparatus of the random access type is characterized by improved response to failures in insertion of electronic components and improved stability of insertion.

On the other hand, since different types of components differ in the shape and size of the body portion and in the diameter of the lead wires, the pitch with which the end of the lead wires is bent is not the same. Thus, when different types of electronic components must be continuously inserted, it is desired to provide an arrangement for making the pitch of the bent lead wires variable.

Japanese Patent Publication No. 286044/1964, which corresponds to the document NL—C—106422, discloses such an arrangement for making variable the pitch of the lead wires to be inserted into apertures of a print circuit board. The disclosed arrangement comprises a pair of forming elements for deforming lead wires to form parallel ends, one of said elements being fixed and the other being movable.

Further, an insertion apparatus adapted to automatically change the pitch during the component insertion cycle is disclosed in USP NO. 3,539,086. According to this apparatus, an electric component assembly comprising different types of electric components arranged in the order of insertion and, e.g., in band form shown in Fig. 2 is prepared and the taped electric component assembly is fed into an insertion head which is movable only vertically, said insertion head having a pair of cutters for cutting and shaping the lead wires, where the components are successively inserted while changing the distance between the lead wires of the electronic component by changing the pitch between said cutters.

However, this variable pitch type insertion apparatus has the following drawbacks.

A plurality of types of components must be sequentially arranged in the order of insertion and formed into a taped band-like assembly. To this end, first, a taping machine must be used. Secondary, taping parts must be stocked for this taping machine, causing a great loss in management control. Further, even if a failure in insertion takes place for one reason or another during operation of the insertion apparatus, it is impossible to reinsert the same type of component. That is, this insertion apparatus presents the same problems as those inherent to the first type of apparatus. Further, in this apparatus, since the electronic component assembly is positioned close to the insertion head, it is impossible to rotate the insertion head around an axis perpendicular to the print circuit board and hence to insert electronic components into the print circuit board with the direction of insertion changed through a predetermined angle, e.g., 90°, which is very disadvantageous to the design or production of circuit boards.

## Disclosure of the Invention

This invention as claimed is characterized by the provision of a tape moving table capable of holding different types of tape-like electronic component assemblies each comprising the same type of electronic components spaced a predetermined distance apart from each other and having lead wires axially extending from its body and also capable of moving a required electronic component assembly to a predetermined component feed position, an insertion head for cutting off electronic components from said electronic component assemblies, deforming the lead wire ends and inserting the deformed lead wire ends into apertures in a print circuit board, said insertion head having means for changing the insertion pitch of lead wires by making use of said deformation of lead wire ends, and drive means movable between said predetermined component feed position and an insertion position not interfering with the movement of said moving table and rotatable around an axis perpendicular to a print circuit board so that at said insertion position the direction of insertion of electronic components into the print circuit board can be changed, said drive means being disengageably connected to said pitch changing means of said insertion head at a fixed portion independent of said insertion head so as to drive said pitch changing means. Thus, the invention has the advantage of being capable of selecting electronic components at random without having to sequentially arrange electronic components and has additional merits of being capable of changing the insertion pitch of electronic components and of not being limited in the direction of insertion of electronic components into the print circuit board.

## Brief Description of Drawings

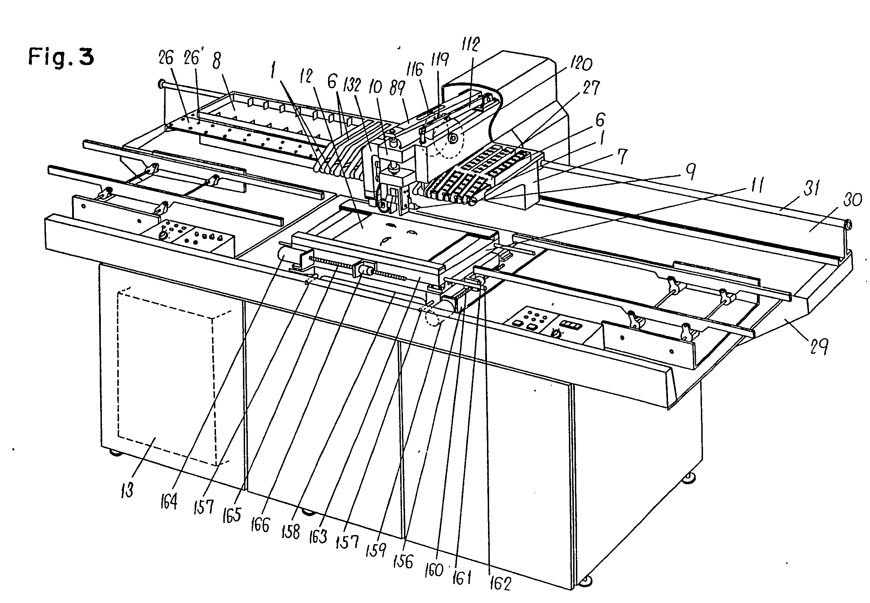

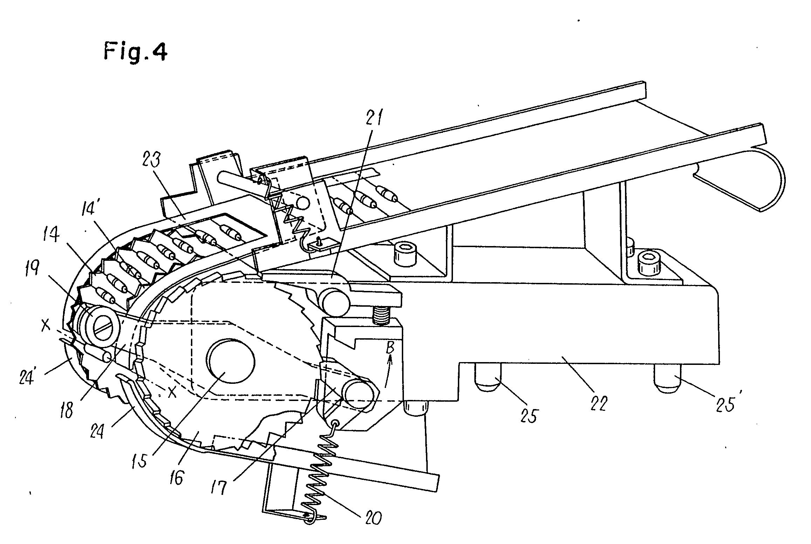

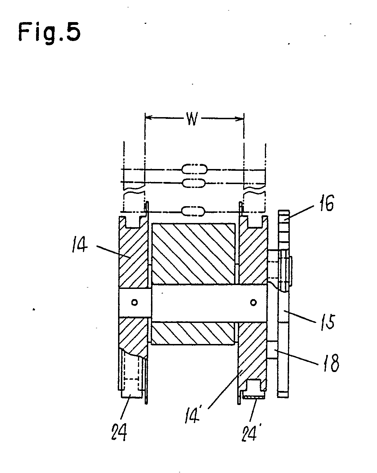

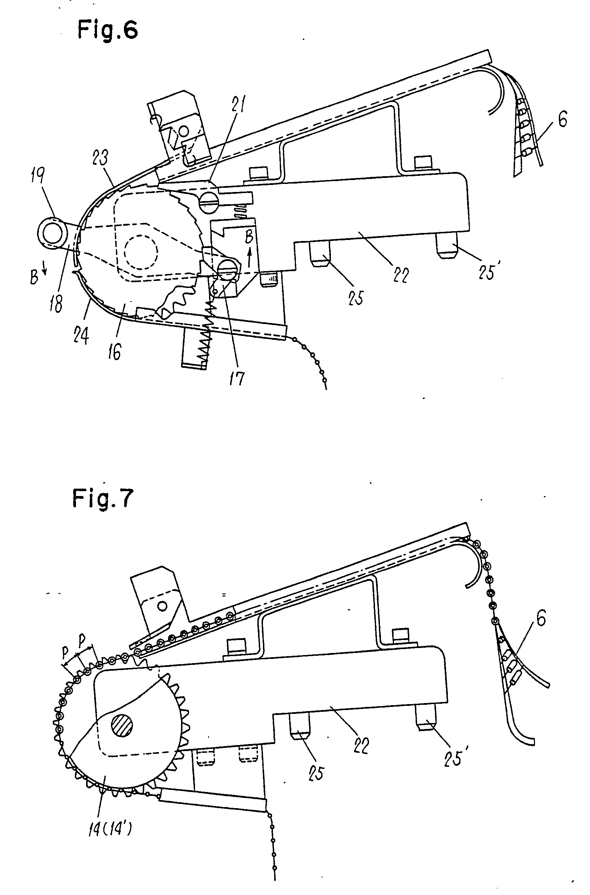

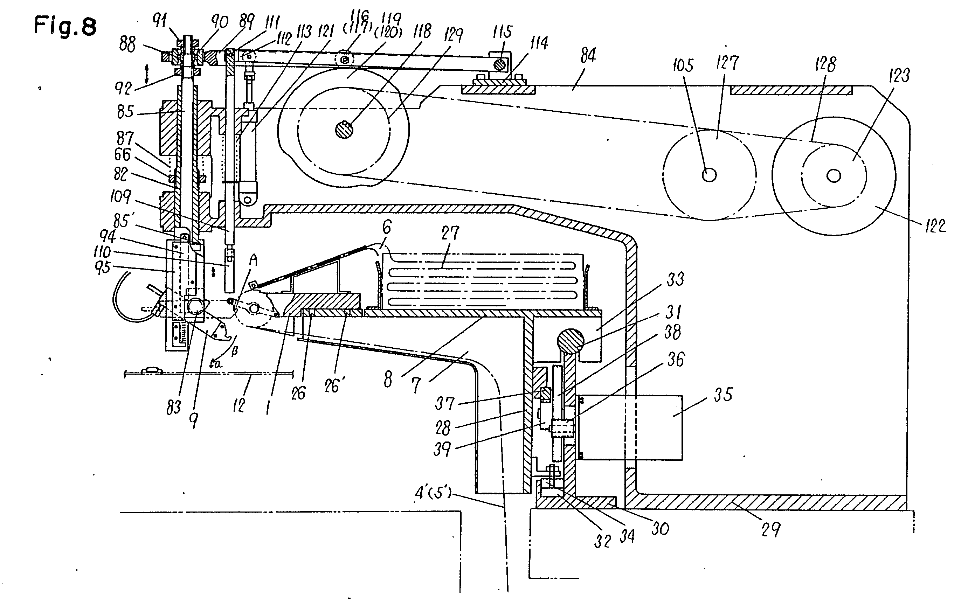

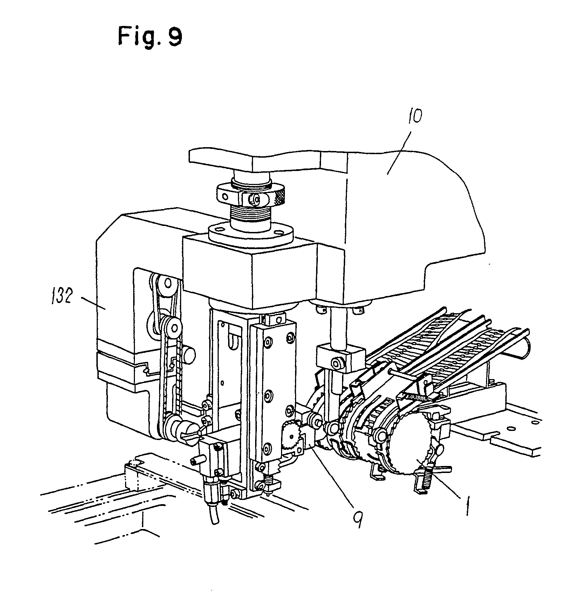

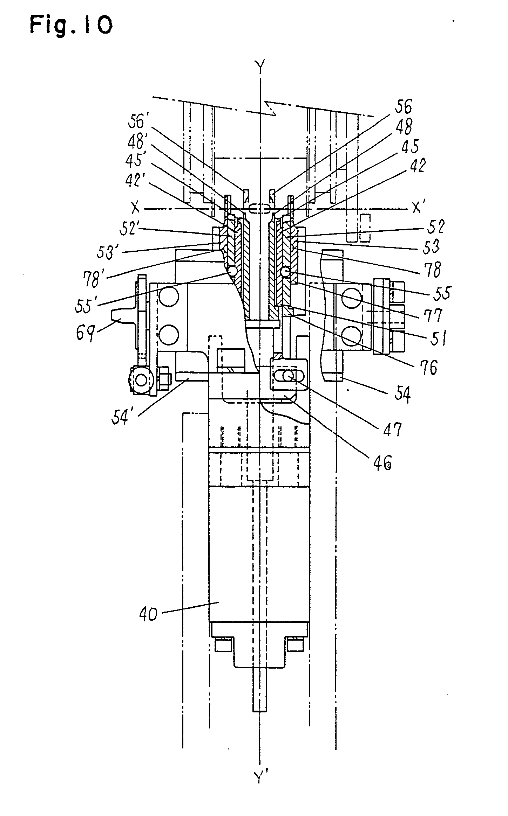

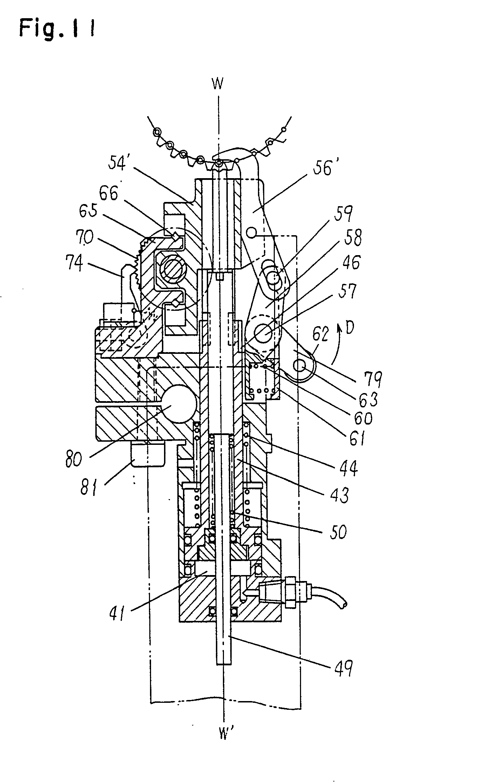

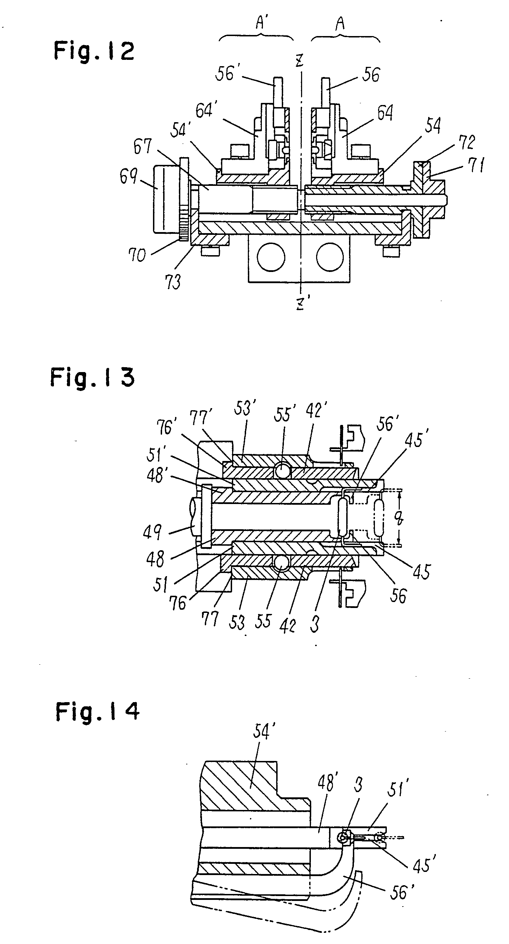

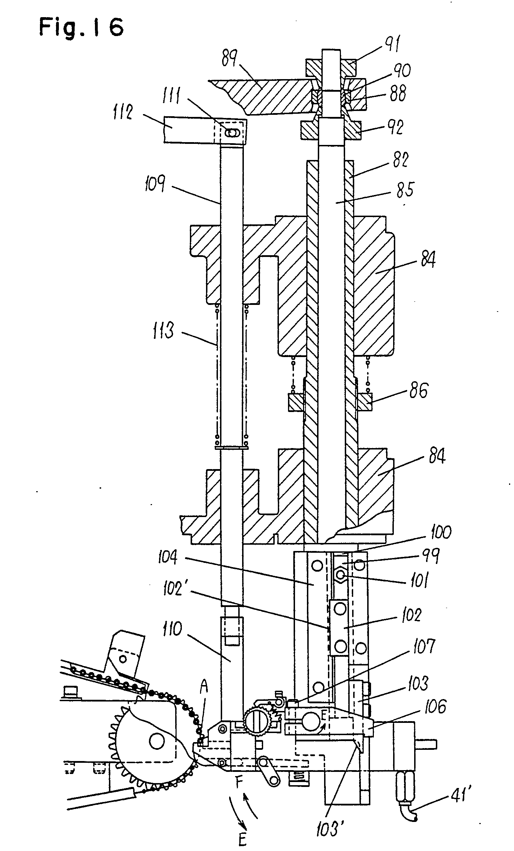

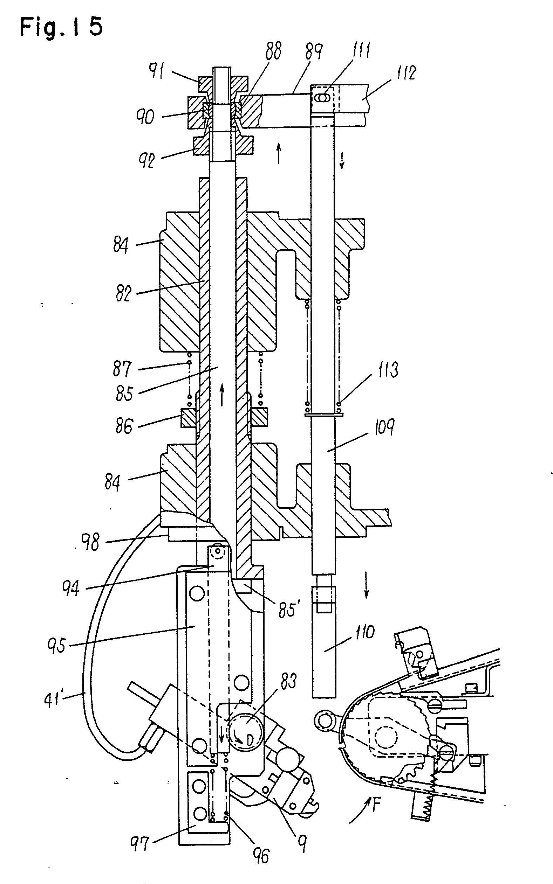

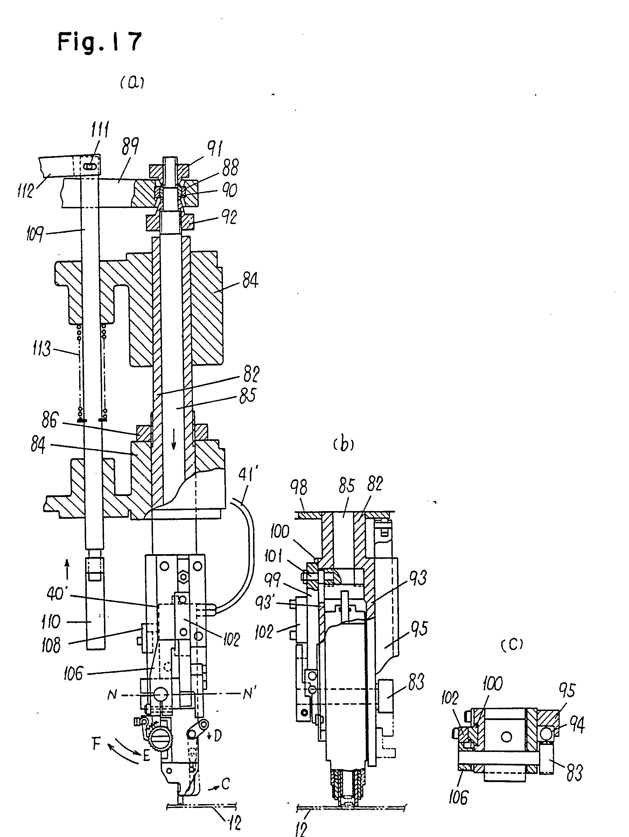

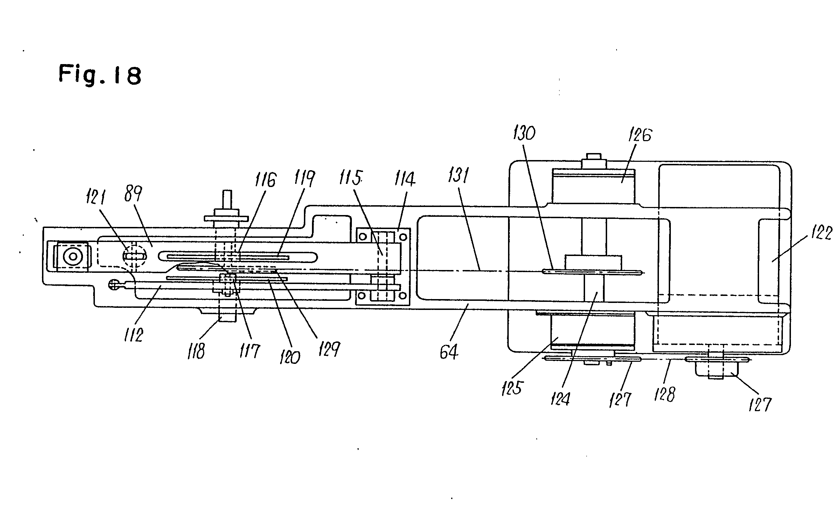

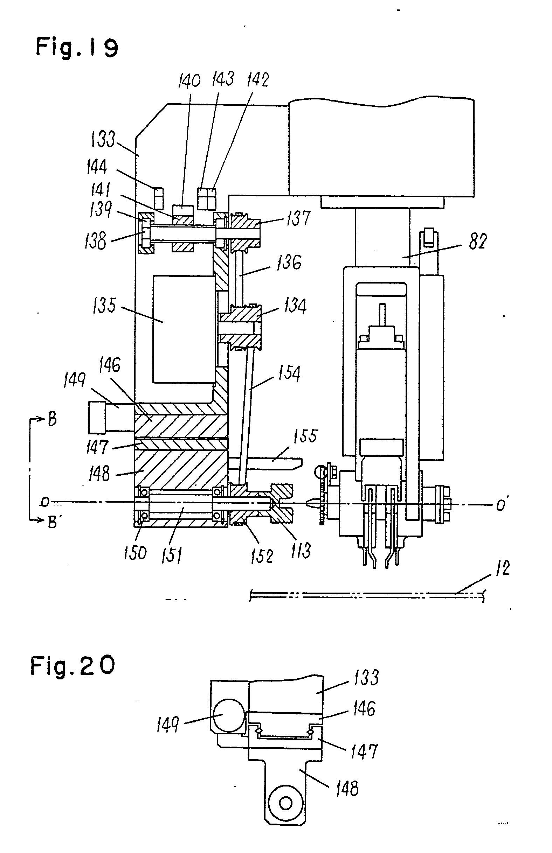

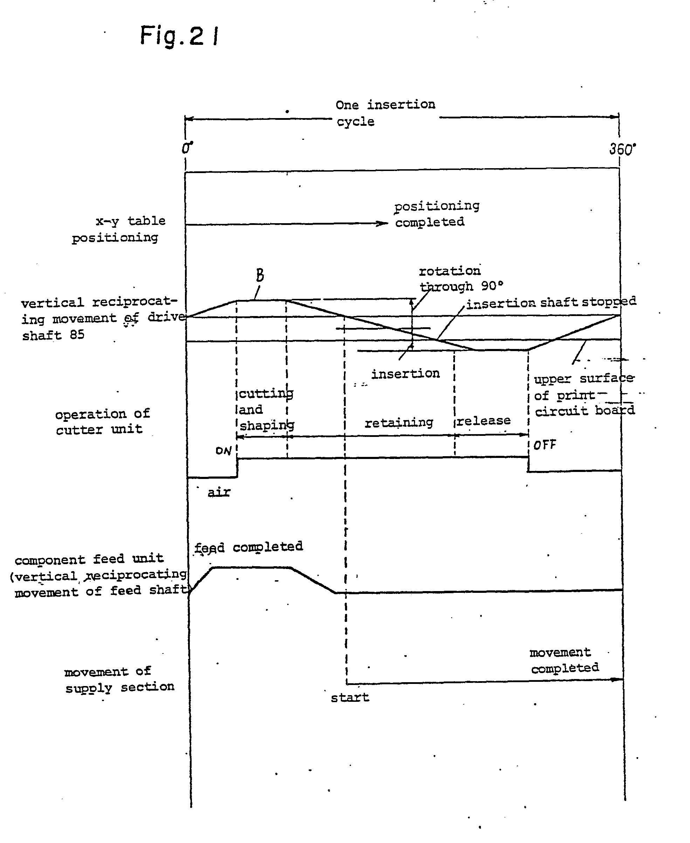

Fig. 1a is a view of a resistor; Fig. 1b is a view of a diode; Fig. 1c is a view of a band-like electronic component assembly used in an electronic component insertion apparatus according to an embodiment of the present invention; Fig. 2 is a schematic view illustrating a conventional method of inserting components; Fig. 3 is a perspective view of an electronic component insertion apparatus according to an embodiment of the invention; Fig. 4 is an enlarged perspective view of a tape feed unit in said electronic component insertion apparatus; Fig. 5 is a front view, in section, of said tape feed unit; Fig. 6 is a side view of said tape feed unit; Fig. 7 is a lateral sectional view of said tape feed unit; Fig. 8 is a lateral sectional view of an electronic component insertion apparatus according to an embodiment of the present invention; Fig. 9 is an enlarged perspective view of the principal portion of said electronic component insertion apparatus; Fig. 10 is a plan view of a cutter unit; Fig. 11 is a front sectional view of said cutter unit; Fig. 12 is a side view, partly in section, of said cutter unit; Fig. 13 is an enlarged sectional view of the principal portion of said cutter unit; Fig. 14 is an enlarged lateral sectional view of the principal portion of said cutter unit; Fig. 15 is an enlarged lateral sectional view of an insertion head; Fig. 16 is a view looking at the insertion head from the back side thereof, Fig. 17a is a side view with said insertion head in the insertion state directed in the same direction as in Fig. 16; Fig. 17b is a front sectional view of the principal portion of said insertion head; Fig. 17c is a sectional view taken along the line N—N' in Fig. 17a; Fig. 18 is a plan view of the insertion head; Fig. 19 is a front view of a drive section for changing the pitch width of the cutter unit; Fig. 20 is a view taken in the direction of arrow B—B' in Fig. 19; and Fig. 21 is a timing chart showing the inserting operation of the electronic component insertion apparatus.

## Best Mode for Carrying Out the Invention

An embodiment of the present invention will now be described with reference to Figs. 3 et seq.

The numeral 1 denotes tape feed units each mounting thereon a band-like electronic component assembly 6 in which a plurality of equispaced electric components 3 having axially extending lead wires 2a, 2b are fixed in position by bendable tapes 4 and 5 (Fig. 1c) such as paper tapes. The numeral 7 denotes a feed means indicating body (hereinafter referred to as the unit moving table) which carries thereon said tape feed units 1 and component storing sections 8 arranged in a plurality of lines rearwardly of said tape feed units 1 and which is adapted to travel back and forth to move any desired tape feed unit 1 to a predetermined component take-out position. The numeral 9 denotes an insertion head (hereinafter referred to as the cutter unit) for cutting off the lead wires of components from the tapes at the predetermined component take-out position, shaping the lead wires into predetermined form, holding the lead wires guided in guide grooves and moving them in rotation to a print circuit board 12 to insert them into the latter. The numeral 132 denotes an external drive section for changing the insertion pitch of the cutter unit 9 at the origin stop position. The numeral 11 denotes a board moving section (X-Y table) for holding the print circuit board 12 which is set in position, and moving it back and forth to determine the insertion position of the print circuit board. The numeral 13 denotes a drive control section for controlling the inserting operation of said unit moving table 7, board moving section 11 and insertion head assembly 10.

First, the tape feed unit 1 will be described.

In this embodiment, as shown in Fig. 1c, the same type of components 3 are taped at equal intervals by adhesive tapes 4 and 5.

In Figs. 4 through 7, ratchet wheels 14, 14' serve to feed the band-like component assembly 6 through a constant pitch P, said wheels being provided with feed teeth matched with said pitch P. The ratchet wheels 14, 14' are fixed on a rotary shaft 15 in such a manner that they are spaced apart from each other by a distance slightly smaller than the taping inner width W, one end of said rotary shaft 15 having attached thereto a ratchet wheel 16 having the same number of teeth as said ratchet wheels 14, 14'. Pivotally mounted on the rotary shaft 15 is a lever 18 having attached thereto a pawl 17 meshing with the ratchet wheel 16, the other end of said lever 18 carrying a roller 19 for reducing the frictional resistance when the lever 18 is pushed. The numeral 20 denotes a spring serving to hold down the pawl and to return the lever 18, and 21 denotes a ratchet wheel arresting pawl, the timing between the ratchet wheels 14, 14' and 16 being so adjusted that the taped components 3 come to a predetermined feed line X—X (a position where they are cut by the cutter unit 9).

In addition, the rotary shaft 15 is supported by a tape feed unit body 22.

Keep plates 23, 24, 24' for preventing the tapes from rising are attached to the unit body 22.

With the construction thus made, when the lever 18 is turned in the direction of arrow B to move the ratchet wheel 16 through one tooth, the ratchet wheels 14, 14' feed the taped components 3 through the pitch P, so that the components 3 can be moved one by one to the predetermined feed line X—X'.

The feed unit 1 has fixing pins 25, 25' on its base, so that a plurality of such feed units can be mounted on the unit moving table 7 by fitting their fixing pins into holes 26, 26' formed at predetermined intervals of space in the unit moving table 7.

The unit moving table 7 will now be described with reference to Figs. 3 and 8.

The unit moving table 7 has mounted thereon the tape feed units 1 engaged by the attaching pins 26, 26' and is provided with the taped component storing sections 8, the number of which corresponds to that of said tape feed units 1.

From components boxes 27 set in the component storing sections 8, the taped bank-like component assemblies 6 are fed to the tape feed units 1.

The unit moving table body 28 is supported by a parallel slide shaft 30 and roller groove 32 provided in a rail 30 attached to the apparatus body 29 through plain bearings 33 and cam followers 34, so that the unit moving table body 28 is slidable on the rail 30.

The numeral 35 denotes a pulse motor for driving said tape feed unit moving table 7, said motor being fixed to the rail 30. The numeral 36 denotes a pinion and 37 denotes a rack meshing with the pinion 36 through idler gears 38 and 39, said rack being fixed to the moving table body 28. Tapes and feed units that are selected by rotation control of said drive pulse motor 35 are successively transferred to the front of the insertion head 10.

Subsequently, the band-like component assembly 6 is cut by a cutter (to be later described) and thereby separated into the components 3 and remaining portions 4', 5' (tape scraps), with the latter becoming longer and longer and flowing downward under gravity.

Fig. 9 is a perspective view, showing the relation of the principal portions of the present invention. Fig. 9 will now be described with reference to Figs. 10 through 21. In Figs. 10—14, the numeral 40 denotes a cutter unit body constituting a cylinder 41, having a piston 43 installed therein through a compression spring 44, said piston having a shaping element 42 at its front end. In the front inner side of the shaping element 42, there are a pair of U- or V-shaped grooves 45, 45' which are provided in correspondence to the insertion pitch $q$ of the print circuit board 12 and along the lateral centerline W—W', and the other end thereof has an elongated opening so that it is slidable in the X—X' direction with respect to a pin 47 pressed into a block 46 attached to the front end of the piston 43. Pushers 48, 48' are installed inwardly of the grooves 45, 45' so that they are slidable in the Y—Y' direction, the end surfaces of said pushers on the Y' side extending through the piston 43 and contacted with the lower portion of a rod 49 pressed to the Y side by a compression spring 50 and urged to slide, so that they are pushed to the Y side into contact with the stop portion of the shaping elements 42, 42' and thereby stopped.

The front outer sides of the shaping elements 42, 42' are formed with grooves allowing male cutter blades 52, 52' to slide therein.

Female cutter blades 53, 53' fixed to independent moving tables 54, 54' hold said male cutter blades 52, 52' between the shaping elements 42, 42', forming a pair of cutters each. Balls (steel balls) 55, 55' contact the middle holes of the male cutter blades 52, 52' and enter holes having a concave surface in the grooves outside the shaping elements 42, 42', normally said ball connecting the shaping elements 42, 42' and male cutter blades 52, 52'.

Holder levers 56, 56' are respectively supported by the moving tables 54, 54', and the elongated opening of one holder lever engages a pin 59 on a lever 58 fixed to an arm shaft 57 having an arm 79 at one end and supported by the body 40. One end of the lever 58 is contacted with a spring receiver 61 fixed to the body 40 through a compression spring 60. Attached to the arm 79 is a pin 63 carrying a roller 62.

Since the pushers 48, 48', shaping elements 42, 42', male cutter blades 52, 52', female cutter blades 53, 53', balls 55, 55' and levers 56, 56' are built in guide blocks 64, 64' fixed to the moving tables 54, 54', the latter form assemblies A, A' for cutting and shaping the lead wires of electrical components.

The moving tables 54, 54' are slidable in the X—X' direction through a slide base 65 fixed to the body 40 and through a roller 66, and engage screw shafts 67 (right-hand thread) and 68 (left-hand thread) supported by the slide base 65.

The screw shaft 67 is provided with a knob 69 and a toothed portion 70 having teeth cut around the entire circumference thereof. A flange 71 mounted on the front end of a shaft extending through the other screw shaft 68 and a flange 72 on the screw shaft 68 are clamped together by bolts so that they are free to rotate, whereby the moving tables 54, 54' can be adjusted to the zero point with respect to the center Z—Z'.

A pawl 74 supported by a bracket 73 fixed to the slide base 65 engages the toothed portion 70 of the screw shaft 67, and the screw shafts 67 and 68 are locked by the force of a tension spring 75 supported at one end by the bracket 73.

Therefore, by rotating the knob 69 in either direction, the distance between the assemblies A, A' can be changed within a predetermined range.

The above refers to the construction of the cutter unit 9, and its operation will now be described. At the cutting position A, the lead wires 2a, 2b of a component 3 fed to the feed line X—X' will be cut, with the centers of the male and female cutter blades and the X—X' and W—W' lines being adjusted so that they lie in the same plane (Figs. 10—11).

In this condition, when air is fed into the cylinder 41 through an air feed hose 41', the shaping elements 42, 42' are advanced through the intermediary of the piston 43, block 46, and pins 47, 47'. Since the pushers 48, 48' received in the shaping elements 42, 42' are connected by the compression spring 50 and the male cutter blades 52, 52' are connected by the balls 55, 55', they are advanced in a unit.

In due course of time there will be established a state in which the front ends of the pushers 48, 48' cooperate with the holder levers 56, 56' to hold the lead wires 2a, 2b of a component 3 therebetween. Since the force of the compression spring 60 for the holder levers 56, 56' is designed to overcome the force of the compression spring 50 for the pushers 48, 48', the latter are stopped in said state.

Subsequently, the gap between the male and female cutter blades 52, 52' and 53, 53' becomes zero, so that the lead wires 2a, 2b of the component 3 are cut, and the male cutter blades are advanced until their step portions 76, 76' abut against the step portions 77, 77' of the female cutter blades 53, 53'. At this position, the balls 55, 55' escape into concave holes 78, 78' formed in the female cutter blades 53, 53', so that the connection between the shaping elements 42, 42' and the male cutter blades 52, 52' is cancelled, allowing the shaping elements 42, 42' alone to advance until the piston 43 reaches the cylinder end (Fig. 13).

The lead wires 2a, 2b of the component 3 cut during this time are bent by the holder levers 56, 56' and guided by the guides 45, 45' of the shaping elements 42, 42'.

The cutter unit 9, with air supplied thereto, cuts off the component 3 from the taped component assembly and holds it, with the lead wires 2a, 2b shaped into bent form.

At the time of insertion (to be later described), when the arm 79 is rotated in the direction of arrow D, the engagement between the pushers 48, 48' and holder levers 56, 56' is cancelled, allowing the pushers 48, 48' to advance under the action of the compression spring 50 to push out the component 3 (Figs. 13 and 14).

In addition, the numeral 80 denotes a hole formed in the upper portion of the cutter body 80, it being connected to a pinion shaft 83 (to be later described) associated with an insertion shaft 82 (to be later described) by a set screw 81.

The insertion head 10 will now be described with reference to Figs. 3 and 15—18.

The insertion shaft 82 forming the insertion head is vertically slidably supported by the insertion head body 84.

The numeral 85 denotes a drive shaft vertically slidably inserted in the central hole of the insertion shaft 82, and 86 denotes an adjusting nut attached to the middle threaded portion of the insertion shaft 82. The numeral 87 denotes a compression spring interposed between the head body 84 and the adjusting nut 86. The insertion shaft 82 is downwardly urged by the compression spring 87 but it is locked by the step portion 85' of the drive shaft 85.

The numeral 88 denotes a spherical bearing attached to the front end of a head arm 89, and the inner race 90 of said spherical bearing 88 is fixed in position by nuts 91, 92, thereby connecting the drive shaft 85 to the head arm 89.

The numeral 83 denotes a shaft-equipped pinion for rotating the cutter unit body 40, and 93, 93' denote flanges supporting the shaft portion of the shaft-equipped pinion and forming the right and left portion of the front end of the insertion shaft 82.

The numeral 94 denotes a slide rack meshing with the pinion 83; 95 denotes a slide groove in which a slide rack slides; and 96 denotes a compression spring interposed between the interior of the slide rack 94 and a bracket 97, said spring constantly urging the slide rack 94 upwardly against the lower surface 98 of the head body 84 and forming the right-hand portion of the front end of the insertion shaft 82.

The numeral 99 denotes a slider slidable in a groove 100 in the flange 93' on the insertion shaft 82, said slider being connected to the step portion 85' of the drive shaft 85 through a pin 101.

Attached to the slider 99 are a control block 102 for controlling the play of the cutter unit body 40 during insertion (to be later described) and a cancelling cam for rotating in the direction of arrow D the arm 79 of the holder levers 56, 56' for cancelling clamp on the component 3. The numerals 104 and 105 denote keep plates for the slider 99. A control lever 106 attached to the end of the pinion shaft 80 is adjusted and fixed in position by a set screw 107 so that it will abut against the abutment surface 102' of the control block 102 during insertion.

The numeral 108 denotes a stop whereby when the cutter unit body 40 is rotated into its downwardly extending vertical state, the rotation is stopped by the rear end of the cutter unit body 40.

The numeral 109 denotes a feed shaft for driving the lever 18 of the tape feed unit 1, said feed shaft being vertically movably supported by the insertion head body 84. The numeral 110 denotes a feed block attached to the front end of the feed shaft 109 and adapted to abut against the roller 19 of the lever 18 during insertion. The numeral 111 denotes a pin for connecting the feed shaft 109 to a feed arm 112.

The numeral 113 denotes a compression spring interposed between the insertion head body 84 and the feed shaft 109, constantly urging the latter downwardly.

In addition, the head arm 89 and feed arm 112 are given a vertical movement around the axis of a pin 115 supported a bracket 114 attached to the upper portion of the head body 84, by an insertion plate cam 119 and feed plate cam 120 attached to a cam shaft 118 through cam followers 116 and 117, respectively. Further, the head arm 89 and feed arm 112 are positively given a vertical movement conforming to the cam surface by a pull cylinder 121 and compression spring 113.

The operation of the drive shaft 85, insertion shaft 82 and cutter unit 9 caused by the insertion plate cam 119 will now be described with reference to Figs. 15—17.

When the cutter unit 9 is at the origin (start) position 0° shown in Fig. 15, it is at a position (downwardly inclined at an angle of 30° to 60°) where it is out of danger of collision with the tape feed unit 1.

The insertion plate cam 119 begins to rotate, lifting the drive shaft 85 until the upper dead point of the cam is reached. As the drive shaft 85 is lifted, the insertion shaft 82, which is arrested by the step portion of the drive shaft, is also lifted. The pinion shaft 83 supported by the front end flanges 93, 93' of the insertion shaft 82 is turned counterclockwise (in the direction of arrow F) as a result of this lifting movement since the slide rack 94 meshing with the pinion shaft 83 is in contact with the lower surface 98 of the head body, thereby turning the cutter unit 9 counterclockwise until the upper dead point of the insertion plate cam 119, where it is brought to its horizontal state. With this position taken as the cutting position A (Fig. 16), if the positional relation between the tape feed unit 1 and the cutter unit 9 is as shown in Figs. 10 and 11, the component 3 fed to the feed line X—X' from the tape feed unit 1 can be cut off from the tapes, shaped and held by supplying air to the cylinder 41, as described above (Figs. 13, 14 and 16).

When the component 3 is held by the cutter unit 9, the drive shaft 85 begins to descend and the insertion shaft 82 downwardly urged by the spring 87 also begins to descend.

When this lowering movement is started, the slide rack 94, which is constantly upwardly urged by the compression spring housed therein, is relatively pushed up according to the lowering stroke, rotating the pinion 83 meshing with said rack in the clockwise direction E, with the result that the cutter unit body 40 is also rotated clockwise, and with the legs 2a, 2b (lead wires) of the component positioned above the print circuit board, the rear end 40' of the cutter unit body 40 abuts against the stop 108, thus making ready for insertion. When the insertion shaft 82 is lowered in its vertical attitude through a fixed distance from this position, the adjusting nut 86 strikes the insertion head body 84 to stop the lowering of the insertion shaft 82. At this time (with adjusting nut 86 assuming the position where it contacts the insertion head body 84), if the front ends of the shaping elements of the cutter unit 9 are adjusted to contact the upper surface of the print circuit board, the guide grooves 45, 45' of the shaping elements can be brought to the insertion holes.

Even after the stoppage of the lowering of the insertion shaft 82, the drive shaft 85 continues to lower, and the slider 99 connected by the pin 101 also lowers along the groove 100 of the flange 93'. According to this lowering stroke, the control surface 102' of the control block 102 attached to the slider 99 immediately contacts the control lever 106, locking the cutter unit body 40 against rotation and rotating the holder levers 56, 56' in the direction of arrow C (Fig. 17a) by the cam surface 103' of the cam block 103 through the roller 62 on the arm shaft 57, thereby releasing the component (Figs. 13 and 14).

When the holder lever 56, 56' release the component 3, the pushers 48, 48' push out the component 3 downwardly by the force of the compression spring 50, as described above, causing the (lead wire) guides 45, 45' of the shaping elements already guided to destination for insertion into the print circuit board to guide and insert the lead wires 2a, 2b of the component 3.

To push out the component reliably, the rear end of the rod 49 of the pushers 48, 48' is pressed down by the step portion 85' of the drive shaft 85 until completion of insertion.

When the drive shaft 85 completing insertion reaches the lower dead point, the supply of air to the cylinder 41 of the cutter unit body 40 is interrupted to allow the piston 43 to return to its original position.

When the lower dead point passed, first the drive shaft 85 alone begins to ascend, performing the operation reverse to that for lowering of the step portion 85', and then the insertion shaft 82 is arrested by the step portion 85', so that they begin to ascend in a unit. Then the rack 94' again comes in contact with the lower surface 98 of the head body, and the pinion 83 and cutter unit body 40 are rotated counterclockwise to return to the origin 0° position. This is one cycle of inserting operation.

The driving relation of the insertion head 10 will now be described.

In Fig. 18, the numeral 122 denotes a geared motor attached to the head body 84.

The numeral 123 denotes a sprocket attached to the output shaft of the geared motor 122, and 124 denotes a transmission shaft supported by the head frame 84 and having a clutch 125 and a brake 126 on its opposite ends. A sprocket 127 attached to the clutch 125 is connected to the geared motor by a chain 128.

Sprockets 129 and 130 are attached to the cam shaft 118 and transmission shaft 124, these two shafts being interconnected by a chain 131.

With the construction thus made, the rotation of the geared motor 122 is transmitted to the cam shaft 118, and as the latter is rotated, the inserting operation including the feeding of said tape feed unit 1 and the movement of the insertion shaft is performed.

The drive section 132 for changing the distance between the assemblies A, A' of the cutter unit 9 will now be described with reference to Figs. 19 and 20.

The numeral 133 denotes the frame of the drive section attached to the insertion head body 84 of the head assembly 10, said frame 133 carrying a pulse motor 135 having a double toothed pulley 134 mounted thereon and a threaded shaft 138 having a toothed pulley 137 mounted thereon which is rotated by the toothed pulley 134 through a toothed belt 136. The threaded shaft 138 is supported in bearings 139 mounted on the frame 133 and carries on its threaded portion a movable block 141 having a detection piece 140. Attached to the frame 133 along the path of travel of the detection piece 140 are sensors for detecting the detection piece 140, i.e., sensor 142 (for overrun), sensor 143 (for origin position) and sensor 144 (for overrun).

At the bottom of the frame 133, there are slide bases 146 and 147 with rollers 145 therebetween, the movable base 147 having attached thereto a frame 148 having a bearing portion coaxial with the screw shaft 67 of the cutter unit 9 at the origin position (0—0') of the insertion head assembly 10. The movable base 147 together with the frame 148 is moved back and forth through a predetermined stroke toward the insertion shaft 82 by the cylinder 149 attached to the frame 133.

The bearing portion of the frame 148 carries therein a rotary shaft 150 through bearings 150, said rotary shaft carrying on its front end a toothed pulley 152 with a connector disk 153 having a groove, said pulley being driven from the double toothed pulley 135 of the pulse motor 135.

Further, the frame 148 has a guide bar 155 fixed thereto which, when the frame 148 is advanced, opens the pawl 74 locking the assemblies A, A' of the cutter unit 9 against their movement.

The related operation of the insertion head assembly 10 and the cutter unit 9 will now be described.

When the insertion head assembly 10 completes the insertion of all the electric components 3 having the initially determined insertion pitch, the insertion shaft 82 stops at the origin position (0—0'), the air cylinder 149 of the drive section 132 advances the frame 148, the guide bar 155 opens the pawl 784 of the cutter unit 9 to unlock the screw shaft 67 and concurrently therewith the groove of the connector disk 153 receives the knob 69 of the screw shaft 67 to interconnect the rotary shaft 151 and screw shaft 67. The data on the insertion pitch for the next insertion is transferred from the control section 13 to the pulse motor 135, whereby the latter is rotated to give the predetermined rotational value to the rotary shaft 151 through the screw shaft 151 so as to change the distance between the assemblies A and A'. Upon completion of change, the air cylinder 149 is actuated to retract the frame 148, so that the guide bar 155 leaves the pawl 74 and at the same time as the pawl 74 locks the toothed portion 70, the groove of the connector disk also leaves the knob 69.

The distance between the assemblies A and A' of the cutter unit 9 is thus changed, and the insertion of the electric component 3 with the insertion pitch having this distance is started. Thereafter, if a plurality of insertion pitches are required, the operation described above is repeated.

The direction in which the groove of the connector disk 153 and the knob 69 engage each other is adjusted by locating the origin with respect to each other, and because of the locking there is no possibility of deviation of the non-operation band.

The board moving section 11 will now be described with reference to Fig. 3.

The numeral 156 denotes a movable base on the apparatus body 29 carrying the board moving section 11. The numeral 157 denotes a Y-direction slide shaft fixed to the base 156.

The numeral 158 denotes a Y table slidable on the slide shaft 157. The numeral 139 denotes a pulse motor attached to the base 156, and the numerals 160 and 161 denote a ball screw and a ball nut which are used to drive the Y table 158, said ball screw 160 being directly connected to the pulse motor 159, said ball nut being fixed to the Y table 158. Similarly, the numeral 162 denotes a slide shaft fixed on the Y table 158, and 163 denotes an X table slidable on the slide shaft 162. The numeral 164 denotes a pulse motor attached to the Y table, and 165, 166 denotes a ball screw and a ball nut which are used to drive the X table, said ball screw 165 being directly connected to the pulse motor 164 and said ball nut 166 being fixed to the X table 163.

The arrangement and operation of the principal portions constituting the present apparatus have been described so far. Finally, their related operation will be described with reference to Fig. 21 showing a timing chart.

This timing chart shows one cycle in insertion.

At the start position (at 0° in the chart), the X and Y tables 158 and 163 are stopped at a predetermined position on the print circuit board 12. Further, the component 3 to be inserted has been prepared at a position one pitch short of the cutting position A by the tape feed unit 1 and tape feed unit moving table 7. Further, the cutter unit 9 is waiting at the origin position in the cylinder OFF condition. Subsequently, when an instruction to start insertion is given, the X and Y table 158 and 163 start the positioning of the print circuit board 12 so that the component 3 at the A position can be inserted into the correct hole. Further, the cutter unit 9 is immediately moved to the A position and concurrently therewith the pusher 110 of the tape feed shaft 109 is lowered, pushing the lever 18 of the tape feed unit 1 through the roller 19, feeding the tapes by the aforesaid operation, thus ensuring that the component will be on the X—X line before the cutter unit 9 reaches there.

When the cutter unit 9 reaches the A position, the cutter unit body 40 is actuated as previously described to cut off the component 3 and shape it, making ready for insertion. After the front end of the cutter unit 9 passes the region where there is a danger of collision with the tape feed unit moving table 7, the latter starts moving to prepare the next component to be inserted.

Since the positioning of the X and Y tables 158 and 163 has been completed by this time, the shaft 85 starts lowering to enter into insertion operation, thus inserting the component into the correct hole in the print circuit board.

The cutter unit 9 then returns to the origin position and waits for the next instruction for insertion.

One cycle of component insertion is performed in this manner.

While this embodiment has been described with respect to an electronic component having lead wires axially extending from the body, it goes without saying that the variable pitch is applicable also to a component composed of a lead wire alone, or the so-called jumper wire. Further, while the unit moving table 7 has been adapted to be linearly movable in this embodiment, the tape feed units 1 may be arranged on the outer periphery of a disk so that they are capable of rotary movement.

Industrial Applicability

The electronic component insertion apparatus of the present invention does not adopt the method of fixing the insertion head and feeding the tapes, which assemble electronic components, into said insertion head. Because of the facts that in each cycle the insertion head goes to receive an electronic component held by the tapes and fed to the predetermined position and the insertion of the component into the print circuit board is effected at a position different from said receiving position, and that means for driving the pitch change means installed in the insertion head is installed in a part independent of the insertion head, the invention is characterized in that without using an electronic component assembly in which electronic components are sequentially arranged, necessary electronic components can be taken out at random by the insertion head and inserted into the print circuit board. Further, if the pitch drive means and the pitch change means are interconnected, the pitch of insertion of electronic components can be optionally changed. Particularly in the case of the present invention, the pitch drive means and the pitch change means are independent of each other and can be connected and disconnected as desired. Thus, in the condition in which their connection has been cancelled, it is extremely easy to rotate the insertion head around an axis perpendicular to the print circuit board, and there is no danger that the direction of insertion of electronic components into the print circuit board is limited. Therefore, the present invention has achieved the outstanding effect of being capable of changing the pitch for insertion of electronic components, which it has been impossible to attain by the conventional insertion apparatus.

Claims

1. An electronic component insertion apparatus comprising tape feed means (1) for holding and intermittently feeding a tape-like electronic component assembly (6) in which a plurality of electronic components (3) having lead wires (2a, 2b) axially extending from the opposite ends of the body are fixed at predetermined intervals, a feed means support body (7) which supports a plurality of said tape feed means and which moves in such a manner that one of said tape feed means can be brought to a predetermined first position, an insertion head (9) including means (52, 53) for cutting off the lead wires of electronic components, shaping means (42) for bending the end portions of the cut lead wires approximately at right angles in the same direction, said insertion head cutting off an electronic component from the tape-like electronic component assembly at said first position, transferring said cut-off electronic component from said first position to a second position relatively close to the surface of a print circuit board (12), away from the path of travel of said feed means support body and away from said first position, and moving the electronic component in a direction perpendicular to the print circuit board to insert the lead wires into holes in the print circuit board, and a board moving table for moving said print circuit board (12) in a plane including the surface of said board, wherein said insertion head is rotatable around an axis perpendicular to the print circuit board, characterised in that the insertion head includes pitch change means (47, 69) acting on said shaping means (42) to change the pitch between the two bent lead wire ends, and in that drive means (132) are installed in a fixed portion independent of said insertion head and adapted to be removably connected to said pitch change means in response to instructions to drive said pitch change means.

2. An electronic component insertion apparatus as set forth in Claim 1, wherein said feed means support body (7) is arranged to support the tape feed means (1) in juxtaposed relation for linear feed and to move in the direction of said linear feed.

3. An electronic component insertion apparatus as set forth in Claim 1, wherein said feed means support body (7) is adapted to support the tape feed means (1) along a circumference and to be rotated.

4. An electronic component insertion apparatus as set forth in Claim 1, wherein said body of the electronic component is composed of a lead wire.

**Patentansprüche**

1. Eine Vorrichtung zum Einsetzen elektronischer Bauteile, welche aufweist: Bandfüttervorrichtungen (1) zum Halten und absatzweisen Füttern einer bandartigen Anordnung (6) elektronischer Bauteile, in welcher eine Mehrzahl von elektronischen Komponenten (3) mit Führungsdrähten, die sich axial von gegenüberliegenden Enden des Körpers ausstrecken, in festgelegten Intervallen befestigt sind; einen Füttervorrichtungsunterstütztungskörper (7), der eine Mehrzahl der Bandfüttervorrichtungen unterstützt und der sich derart bewegt, daß eine der Bandfüttervorrichtungen in eine erste Position gebracht werden kann; einen Einsatzkopf (9), der Vorrichtungen zum Abschneiden der Führungsdrähte der elektronischen Komponenten aufweist; Formvorrichtungen (42) zum ungefähr rechtwinkligen Umbiegen der Endteile der abgeschnittenen Führungsdrähte in dieselbe Richtung; der Einsatzkopf schneidet ein elektronisches Bauteil von der bandartigen Anordnung elektronischer Bauteile an dieser ersten Position ab, transferiert dieses abgeschnittene elektronische Bauteil von dieser ersten Position zu einer zweiten Position, die relativ nahe an der Oberfläche einer gedruckten Schaltungsplatine (12) ist, und weg von dem Bewegungsbereich des Fütterungsunterstützungskörpers und weg von der ersten Position und bewegt das elektronische Bauteil in eine Richtung senkrecht zur gedruckten Schaltungsplatine, um die Führungsdrähte in Löcher in der gedruckten Schaltungsplatine einzusetzen; und eine Platinenbewegungstafel zum Bewegen der gedruckten Schaltungsplatine (12) in einer Ebene, die die Oberfläche der Platine einschließt, wobei der Einsatzkopf um eine Achse senkrecht zur gedruckten Schaltungsplatine drehbar ist; die Vorrichtung ist dadurch gekennzeichnet, daß der Einsatzkopf Abstandsänderungsvorrichtungen (47, 69) aufweist, die auf die Formvorrichtungen (42) wirken, und den Abstand zwischen zwei gebogenen Führungsdrähten zu ändern, und daß Antriebsvorrichtungen (132) in einem festen Teil unabhängig von dem Einsatzkopf eingebaut sind und so ausgelegt sind, daß sie auswechselbar in Antwort auf Anordnungen, die Abstandsänderungsvorrichtungen anzutreiben, mit den Abstandsänderungsvorrichtungen verbunden sind.

2. Eine Vorrichtung zum Einsetzen elektronischer Bauteile nach Anspruch 1, wobei der Füttervorrichtungsunterstützungskörper (7) so angeordnet ist, daß er die Bandfütterungsvorrichtung (1) daneben zum linearen Füttern und für Bewegungen in Richtung des linearen Fütterns unterstützt.

3. Eine Vorrichtung zum Einsetzen elektronischer Bauteile nach Anspruch 1, dadurch gekennzeichnet, daß der Fütterungsunterstützungskörper (7) so ausgelegt ist, daß er die Bandfütterungsvorrichtung (1) entlang eines Kreisumfanges unterstützt und rotiert werden kann.

4. Eine Vorrichtung zum Einsetzen elektronischer Bauteile nach Anspruch 1, wobei der Körper des elektronischen Bauteils aus einem Führungsdraht besteht.

**Revendications**

1. Appareil d'insertion de composants électroniques comprenant un dispositif (1) d'alimentation à bande destiné à maintenir et faire avancer par intermittence un ensemble (6) de composants électroniques sous forme d'une bande dans lequel plusieurs composants électroniques (3) ayant des fils de connexion (2a, 2b) dépassant axialement des extrémités opposées du corps sont fixés à intervalles prédéterminés, un corps (7) destiné à supporter plusieurs dispositifs d'alimentation de bande et qui se déplace de manière que l'un des dispositifs d'alimentation puisse occuper une première position prédéterminée, une tête d'insertion (9) comportant un dispositif (52, 53) de découpe des fils de connexion des composants électroniques, un dispositif (42) de mise en forme destiné à appliquer les parties d'extrémité des fils de connexion coupés à peu près perpendiculairement à la même direction, la tête d'insertion découpant un composant électronique de l'ensemble de composants électroniques analogue à une bande à la première position, transférant le composant électronique découpé de la première position à une seconde position relativement proche de la surface d'une carte de circuit imprimé (12) à distance du trajet de déplacement du corps de support du dispositif d'alimentation et à distance de la première position, et déplaçant le composant électronique en direction perpendiculaire à la carte de circuit imprimé afin que les fils de connexion soient introduits dans des trous formés dans la carte de circuit imprimé, et une table de déplacement de carte destinée à déplacer la carte de circuit imprimé (12) dans un plan comprenant la surface de la carte, la tête d'insertion pouvant tourner autour d'un axe perpendiculaire à la carte de circuit imprimé, caractérisé en ce que la tête d'insertion comporte un dispositif (47, 69) de changement de pas agissant sur le dispositif (42) de mise en forme afin qu'il change le pas compris entre les deux extrémités pliées des fils de connexion, et en ce qu'un dispositif d'entraînement (132) occupe une position fixe indépendante de la tête d'insertion et est destiné à être raccordé temporairement au dispositif de changement de pas à la suite d'instructions d'entraînement du dispositif de changement de pas.

2. Appareil d'insertion de composants électroniques selon la revendication 1, dans lequel le corps (7) de support de dispositif d'alimentation est destiné à supporter les dispositifs (1) d'alimentation en forme de bande qui sont juxtaposés afin qu'ils avancement linéairement et à se déplacer dans la direction d'avance linéaire.

3. Appareil d'insertion de composants électroniques selon la revendication 1, dans lequel le corps (7) de support de dispositifs d'alimentation est destiné à supporter les dispositifs (1) d'alimentation en forme de bande le long d'une circonférence et est destiné à tourner.

4. Appareil d'insertion de composants électroniques selon la revendication 1, dans lequel le corps du composant électronique est composé d'un fil de connexion.

# Fig. 1

(a)

(b)

(c)

# Fig. 2

Fig.3

Fig.4

EP 0 118 629 B1

3

## Fig.5

Fig.6

Fig.7

# Fig.8

EP 0 118 629 B1

Fig. 9

# Fig. 10

# Fig. I I

**Fig.12**

**Fig.13**

**Fig.14**

Fig. 16

# Fig. 1 5

# Fig. 17

(a)

(b)

(c)

Fig. 18

Fig. 19

Fig. 20

## Fig. 2 |

One insertion cycle

0°                                                                    360°

x-y table
positioning
                    positioning
                    completed

B

vertical reciprocat-
ing movement of drive
shaft 85
                    rotation
                    through 90°
                                        insertion shaft stopped

                    insertion
                                                        upper surface
operation of                                            of print—
cutter unit         cutting         retaining  release  circuit board
                    and
                    shaping

             ON                                         OFF

             air

component feed unit    feed completed
(vertical reciprocating
movement of feed shaft)

movement of                                    movement
supply section                                 completed

                    start